# EUROPEAN PATENT APPLICATION

(11) **EP 2 706 523 A2**
(43) Date of publication of application: **12.03.2014**
(21) Application number: 13178186.6
(22) Date of filing: 26.07.2013
(51) Int. Cl.: G09G 3/00, G09G 3/32, H01L 51/56

(54) **Device and method for repairing display device**

(30) Priority: 11.09.2012 KR 20120100444
(71) Applicant: Samsung Display Co., Ltd., Gyeonggi-Do (KR)
(72) Inventor: Park, Young-Gil, Gyunggi-Do (KR); Lhee, Zail, Gyunggi-Do (KR)
(74) Representative: Mounteney, Simon James

(57) **Abstract**

A repairing apparatus of a display device that includes: a stage (10) where a display device (100) is mounted; a lighting device (20) applying a lighting signal to the display device; and a detector (30) disposed at a distance from the display device and detecting a photon or heat generated from a defect part in a pixel of the display device. An optical microscopic (50), the detector, and a laser repairing device (60) are provided in a light blocking box (40) so that a defect part that cannot be detected by the optical microscopic can be detected using the detector, and the pixel can be repaired to a normal pixel using the laser repairing device, and accordingly the yield can be improved.

## Description

### BACKGROUND OF THE INVENTION

### 1. Field of the Invention

The described technology relates generally to a repairing apparatus of a display device, and a method thereof.

### 2. Description of the Related Art

In general, a display device such as a liquid crystal display (LCD), an organic light emitting diode (OLED) display, and the like is formed by layering a plurality of thin films and wirings. Such a display device may include a pixel that contains an impurity or particle formed on a thin film during a manufacturing process or has a short-circuit in the wiring.

The above information disclosed in this Related Art section is only for enhancement of understanding of the background of the described technology and therefore it may contain information that does not form the prior art that is already known in this country to a person of ordinary skill in the art.

### SUMMARY OF THE INVENTION

The described technology has been made in an effort to provide a repairing apparatus of a display device that can repair a pixel having a defect that cannot be determined by an optical microscopic to a normal pixel, and a repairing method thereof.

A repairing apparatus of a display device according to the present invention includes: a stage where a display device is mounted; a lighting device applying a lighting signal to the display device; and a detector disposed at a distance from the display device and detecting a photon or heat generated from a defect part in a pixel of the display device.

The repairing apparatus may further include a light blocking box surrounding the stage and the detector and blocking introduction of external light into the display device.

The lighting signal may have a signal condition that causes emission of a photon or heat from a defect part of the pixel and simultaneously causes emission of photon or heat less than a light emission unit of the pixel or a signal condition that causes non-light emission of the light emission unit.

The detector may be one selected from a Si-detector having a light receiving part formed of a Si material, an InGaAs-detector having a light receiving part formed of an InGaAs material, a GaAs material, or InGaAsP material, and an InSb-detector having a light receiving part formed of an InSb material.

The light blocking box may block light of a wider wavelength range than a wavelength range of the photon or heat detected by the detector.

The detector may be disposed in an upper or lower side of the stage.

The lighting device may include a lighting probe contacting a pad of the display device and a lighting signal generator generating the lighting signal applied to the lighting probe.

The stage may include a carrying unit carrying the display device and a rotating unit provided in an opening formed in the carrying unit and rotating, and the display device may be mounted in the rotating unit.

The rotating unit may rotate with respect to a rotation shaft that connects the carrying unit and the rotating unit.

The lighting probe may further include an upper probe disposed in an upper side of the state and a lower probe disposed in a lower side of the stage.

The repairing apparatus may further include a laser repairing device disposed at a distance from the display device and repairing the pixel by irradiating laser beam.

The repairing apparatus may further include an optical microscopic disposed in an upper or lower side of the stage and performing an optical test with respect to the pixel of the display device.

A method for repairing a display device according to another exemplary embodiment includes: detecting a defect part in a pixel by performing an optical test on a display device mounted in a stage using an optical microscopic; applying a lighting signal to the pixel by contacting a lighting device to the display device for emission of photons or heat from the defect part in the pixel when the defect part in the pixel is not detected by using the optical microscopic; determining the defect part in the pixel by detecting the photon or heat using a detector; and repairing the pixel by irradiating laser beam to the defect part in the pixel.

The display device and the detector may be provided in a light blocking box that blocks entrance of external light.

The lighting signal may have a signal condition that causes emission of photon or heat from a defect part in the pixel and at the same time causes emission of less photon or heat than the defect part from a light emission portion of the pixel or a signal condition that causes non-light emission of the light emission portion.

The detector may be one selected from a Si-detector having a light receiving part formed of a Si material, an InGaAs-detector having a light receiving part formed of an InGaAs material, a GaAs material, or InGaAsP material, and an InSb-detector having a light receiving part formed of an InSb material.

The method for repairing the display device may further include detecting microphoton or heat generated from a bottom side of the display device by rotating the display device by 180 degrees.

The method for repairing the display device may further include repairing the pixel and then determining whether the repaired pixel is normal using the lighting device.

When the defect part in the pixel is detected using the optical microscopic, the pixel may be repaired by irradiating laser beam to the defect part in the pixel.

According to the present invention, the optical microscopic, the detector, and the laser repairing device are provided in the light blocking box so that a defect part that cannot be detected by the optical microscopic can be detected using the detector, and the pixel can be repaired to a normal pixel using the laser repairing device, and accordingly the yield can be improved.

In addition, a pixel including a defect such as a bright spot, a dark spot, a line failure, and the like can be repaired to a normal pixel without regard to the type of defect, and the repaired pixel can be determined whether to be normal or not by using the lighting device after the repairmen, thereby improving productivity.

At least some of the above and other features of the invention are set out in the claims.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:

FIG. 1 is a schematic diagram of a repairing apparatus of a display device according to an embodiment of the present invention.

FIG. 2 is a top plan view of a stage of the repairing apparatus of the display device according to the embodiment of FIG. 1.

FIG. 3 is a graph illustrating a photon efficiency curved line (a) according to waves of a Si-detector and a photo efficiency curved line (b) according to waves of an InGaAs-detector used as a detector of the repairing apparatus of the display device according to the embodiment.

FIG. 4 is a graph illustrating a photon efficiency curved line (c) according to an InSb-detector used as a detector of the repairing apparatus of the display device according to the embodiment of FIG. 1.

FIG. 5 is a flowchart of a repairing method of the display device according to the embodiment of FIG. 1.

FIG. 6 is a photo illustrating an optical test performed in a pixel using an optical microscopic.

FIG. 7 is a photo of a defect part in the pixel, detected using a detector according to the embodiment of FIG. 1.

FIG. 8 shows a voltage relationship when a black lighting signal is applied to an organic light emitting diode (OLED) display.

FIG. 9 shows a voltage relationship when a lighting signal is applied according to a repairing method of the display device according to the embodiment of FIG. 1.

### DETAILED DESCRIPTION

The present invention will be described more fully hereinafter with reference to the accompanying drawings, in which embodiments of the invention are shown. As those skilled in the art would realize, the described embodiments may be modified in various different ways, all without departing from the scope of the present invention.

The drawings and description are to be regarded as illustrative in nature and not restrictive. Like reference numerals designate like elements throughout the specification. In the drawings, the sizes and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like or similar reference numerals refer to like or similar elements throughout. As used herein, the term "and/or" includes any and all combinations of one or more of the associated listed items.

It will be understood that, although the terms first, second, third etc. may be used herein to describe various elements, components, regions, layers, patterns and/or sections, these elements, components, regions, layers, patterns and/or sections should not be limited by these terms. These terms are only used to distinguish one element, component, region, layer pattern or section from another region, layer, pattern or section. Thus, a first element, component, region, layer or section discussed below could be termed a second element, component, region, layer or section without departing from the teachings of example embodiments of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular example embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments of the present invention are described herein with reference to cross sectional illustrations that are schematic illustrations of illustratively idealized example embodiments (and intermediate structures) of the inventive concept. As such, variations from the shapes of the illustrations as a result, for example, of manufacturing techniques and/or tolerances, are to be expected. Thus, example embodiments of the present inventionshould not be construed as limited to the particular shapes of regions illustrated herein but are to include deviations in shapes that result, for example, from manufacturing. The regions illustrated in the figures are schematic in nature and their shapes are not intended to illustrate the actual shape of a region of a device and are not intended to limit the scope of the inventive concept.

Unless otherwise defined, all terms (including technical and scientific terms) used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Often, a relative size of a leakage current is used or a lighting tester using an optical microscopic is used to detect such a pixel. That is, the optical microscopic is used to find a defect such as the impurity or particle in the pixel or the short-circuit in the wiring and the defect part is repaired. However, when an impurity or particle that is too small to be found through the optical microscopic or short-circuit occurs in wiring, an accurate location of the defect part in the pixel cannot be detected and thus the pixel cannot be properly repaired.

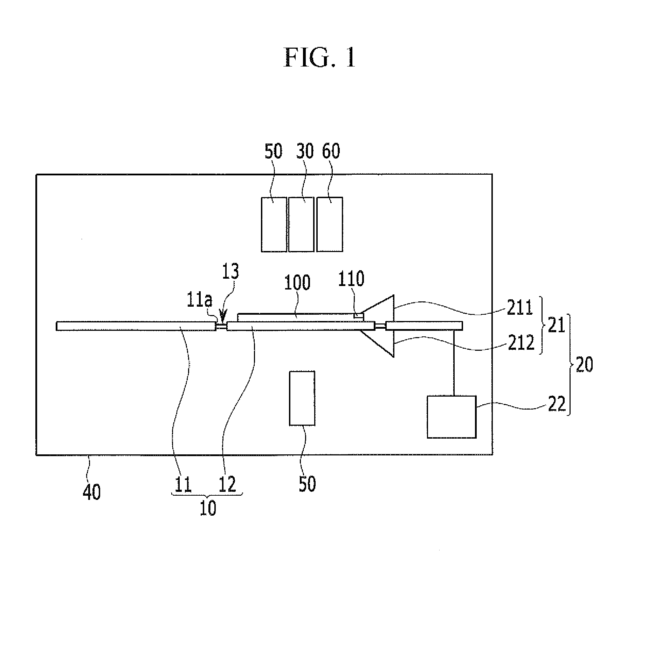

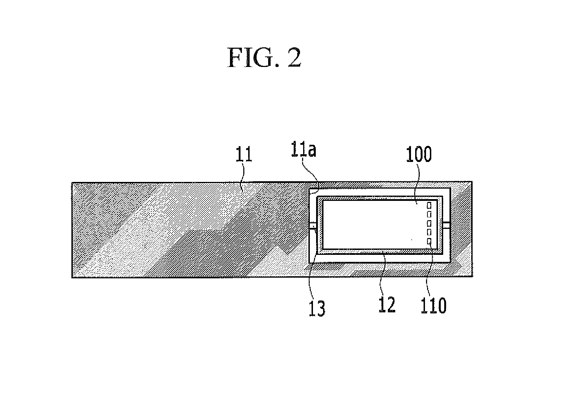

A repairing apparatus of a display device according to an embodiment of the present invention will be described in further detail with reference to FIG. 1 and FIG. 2.

FIG. 1 is a schematic diagram of a repairing apparatus of a display device according to an embodiment of the present invention, and FIG. 2 is a top plan view of a stage of the repairing apparatus of the display device according to the embodiment of the present invention.

As shown in FIG. 1 and FIG. 2, a repairing apparatus of a display device according to an embodiment of the present invention includes a stage 10 in which a display device 100 may be mounted, a lighting device 20 applying a lighting signal to the display device 100, a detector 30 disposed at a distance from the display device 100 and detecting photons or heat generated from a defect part in a pixel of the display device 100 by the lighting signal generated in the lighting device 20, and a light blocking box 40 surrounding the stage 10 and the detector 30 and blocking entrance of external light into the display device 100.

The stage 10 includes a carrying unit 11 carrying the display device 100 and a rotating unit 12 provided in an opening 11a formed in the carrying unit 11 and rotating.

The display device 100 may be a flat display device such as a liquid crystal display (LCD), organic light emitting diode (OLED) display, and the like, and the display device 100 may be mounted in the rotating unit 12. The rotating unit 12 rotates with respect to a rotation shaft 13 that connects the carrying unit 11 and the rotating unit 12.

The lighting device 20 includes a lighting probe 21 contacting a pad 110 of the display device 100 and a lighting signal generator 22 generating a lighting signal applied to the lighting probe 21. The lighting probe 21 includes an upper probe 211 provided in an upper portion of the stage 10 and a lower probe 212 provided in a lower portion of the stage 10. The upper probe 211 may be a lighting probe contacting the pad 110 of the display device 100 when the pad 110 of the display device 100 faces upward where the detector 30 may be provided, and the lower probe 212 may be a lighting probe contacting the pad 110 of the display device 100 when the pad 110 of the display device 100 is inversed by the rotating unit 12 and thus faces downward.

When no photon is detected in the front side of the display device 100, display device 100 may be rotated 180 degrees and the lighting signal may be applied using the lower probe 212 such that the detector 30 can detect photons or heat in the bottom side of the display device 100.

The lighting signal applied to the display device 100 through the lighting probe 21 injects energy like a current to the defect part in a pixel of the display device. In this case, the injected energy may be partially lost in the defect part, and the lost energy may be emitted as photon or thermal energy to the outside.

The detector 30 may detect a location of a defect part in the pixel by detecting the emitted photon or thermal energy. That is, the detector 30 includes a light receiving element such as a photo diode. The light receiving element absorbs the emitted photon of thermal energy and converts the absorbed one into a current. When there is no external light, the detector 30 can detect weak energy emission because a dark current, that is, a current generated from a photo-diode itself may be between 1x10-¹⁵A to 1x10-¹⁹A, which is lower than that of a conventional detector.

The detector 30 may include various detectors that can selectively detect energy of a predetermined wavelength band in order to increase a reception rate of the emitted photon or heat. That is, the detector 30 may be one selected from an Si-detector that can detect a photon of an approximately 100nm to 1200nm wavelength, an InGaAs-detector that can detect a photon of an approximately 800nm to 1800nm wavelength, and an InSb-detector that can detect a photon of an approximately 3.3µm to 5.7µm wavelength or heat.

The Si-detector may be a detector having a light receiving part formed of a Si material, the InGaAs-detector may be a detector having a light receiving part formed of an InGaAs material, a GaAs material, and an InGaAsP material, and the InSb-detector may be a detector having a light receiving part formed of an InSb material.

Thus, the detector 30 can detect an accurate location of a defect part in the pixel that includes a defect such as a bright spot, a dark spot, a line failure, and the like.

In addition, a lighting condition for injection of energy to the defect part may be reinforced to acquire a higher signal than a limit of detection (i.e., several x10⁻¹⁸A to several x10⁻¹⁹ A). In this case, a lighting condition that may be different from a typical lighting condition may be used to prevent energy emission in other areas than the defect part in the pixel.

Although the detector 30 is provided in the upper portion of the stage 10 in the present embodiment of the invention, the detector 30 may be provided in a lower portion of the stage 10, and the optical microscopic 50 that performs optical inspect with respect to pixels of the display device 100 may be provided in the upper or lower portion of the stage 10.

In the present embodiment of the invention, the laser repairing device 60 that repairs a pixel by irradiating laser beam may be provided in the upper portion of the stage 10, but the laser repairing device 60 may be provided in the lower portion of the stage 10. The laser repairing device 60 may repair the pixel by directly irradiating laser beam to the defect part in the pixel when an accurate location of the defect part may be detected by the detector 30.

The detector 30, the optical microscopic 50, and the laser repairing device 60 may all be provided in the upper or lower portion of the stage 10, and may be provided adjacent to each other.

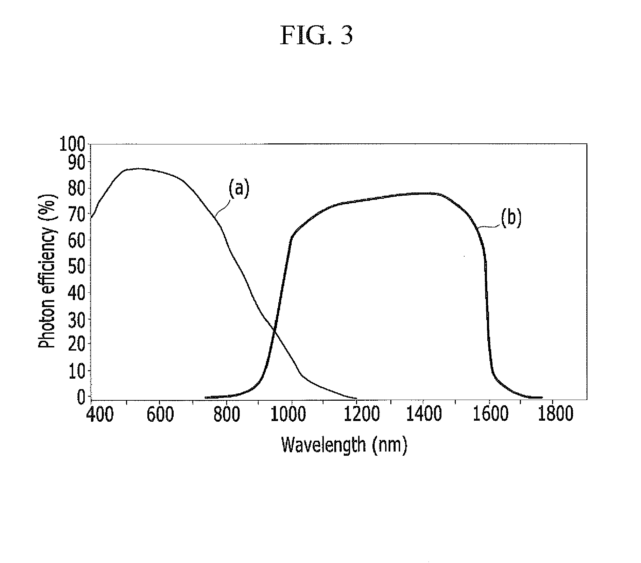

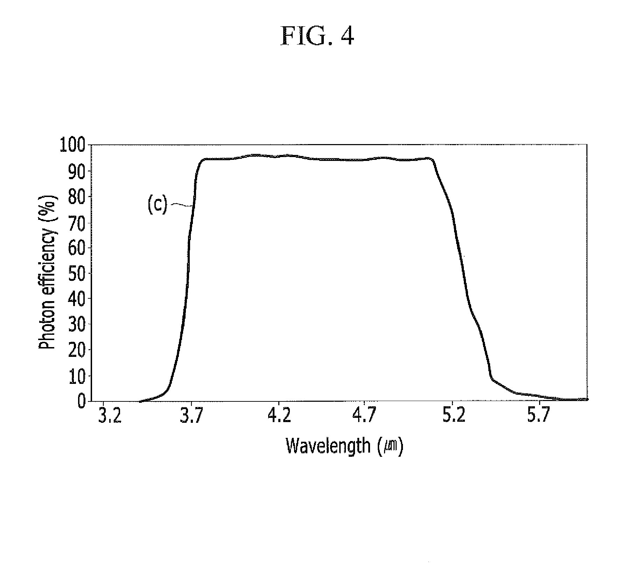

FIG. 3 is a graph illustrating a photon efficiency curved line (a) according to waves of a Si-detector and a photo efficiency curved line (b) according to waves of an InGaAs-detector used as a detector of the repairing apparatus of the display device according to this embodiment of the present invention, and FIG. 4is a graph illustrating a photon efficiency curved line (c) according to an InSb-detector used as a detector of the repairing apparatus of the display device according to the exemplary embodiment.

As shown in FIG. 3 and FIG. 4, the Si-detector can detect a photon of a wavelength of 100nm to 1200nm, the InGaAs-detector can detect a photon of a wavelength of 800nm to 1800nm, and the InSb-detector can detect a photon of a wavelength of 3.3µm to 5.7µm.

In order to receive a weak signal generated from the defect part, the detector 30 may block light of a wider wavelength range than a wavelength range of photon or heat detected by the detector 30. That is, the light blocking box 40 may be made of a steel plate that may be a material blocking light of a wavelength range of 100nm to 6µm. In addition, the light block box 40 may block light of a specific wavelength in consideration of the wavelength range of the photon or heat generated from the defect part and a detection wavelength range of the detector 30.

Therefore, the detector 30 can simply detect weak photon or heat generated from the defect part within a short period of time without interference of external light.

As described, the optical microscopic 50, the detector 30, and the laser repairing device 60 are provided in the light blocking box 40 so that a defect part that cannot be detected by the optical microscopic 50can be detected using the detector 30, and the pixel can be repaired to a normal pixel using the laser repairing device 60, and accordingly the yield can be improved.

In addition, a pixel including a defect such as a bright spot, a dark spot, a line failure, and the like can be repaired to a normal pixel without regard to the type of defect, and the repaired pixel can be determined whether to be normal or not by using the lighting device 20 after the repairmen, thereby improving productivity.

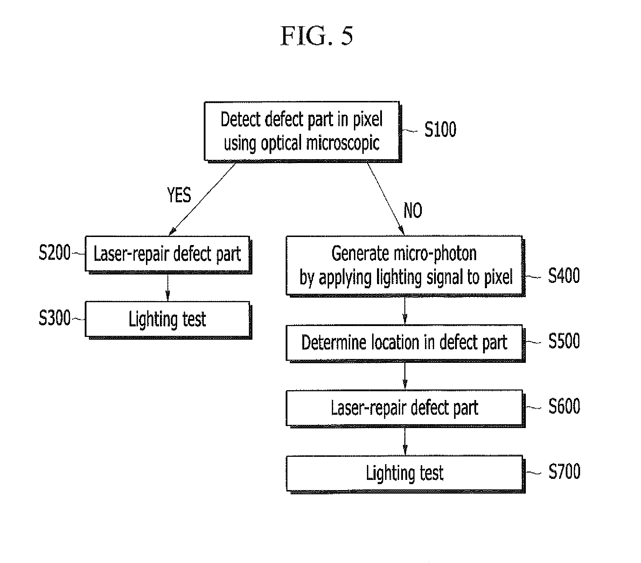

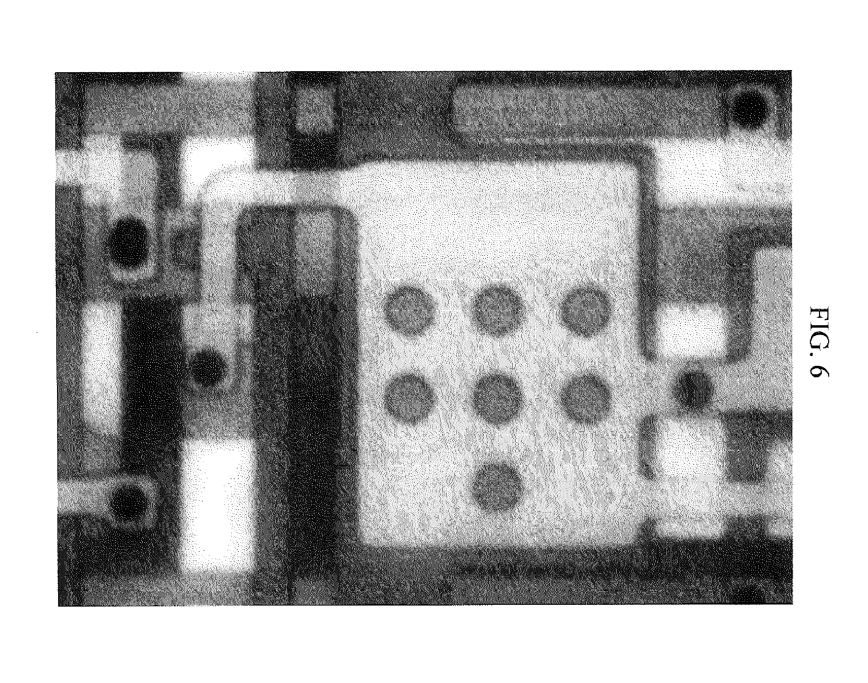

Next, a method for repairing the display device using the repairing apparatus of the display device shown in FIG. 1 and FIG. 2 will be described in further detail with reference to FIG. 5 and FIG. 6.

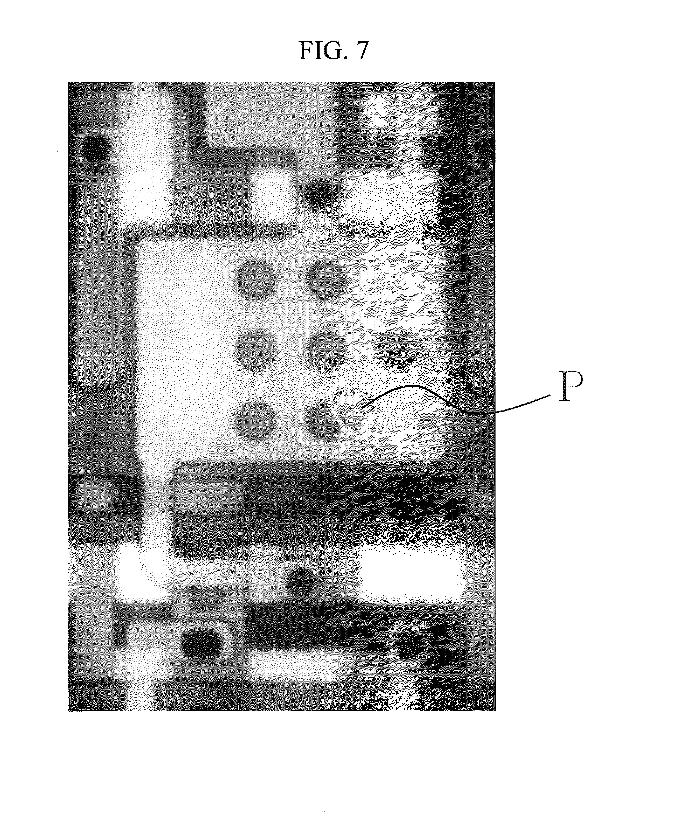

FIG. 5 is a flowchart of a repairing method of the display device according to the embodiment of FIG. 1 and FIG. 2, FIG. 6 is a photo of an optical test performed in the pixel using an optical microscopic, and FIG. 7 is a photo determining a defect part in the pixel using the detector according to this embodiment.

First, as shown in FIG. 5, an optical test may be performed in the display device 100 mounted in the stage 10 using the optical microscopic 50 to detect a defect part in the pixel (S100).

Next, when the defect part is detected in the pixel using the optical microscopic 50, the pixel may be repaired by irradiating a laser beam to the defect part in the pixel (S200). In addition, the pixel may be repaired and then it may be determined whether the pixel is normal using the lighting device 20 (S300).

Next, as shown in FIG. 6, when the defect part is not detected in the pixel by the optical microscopic 50, a lighting signal may be applied to the pixel by contacting the upper probe 211 of the lighting device 20 to the display device 100 as shown in FIG. 5 (S400). The defect part in the pixel emits photons or heat by the lighting signal, and a light emission unit of the pixel has a signal condition that causes the light emission unit to emit less photons or heat compared to the defect part or has a signal condition that causes the light emission unit not to emit light.

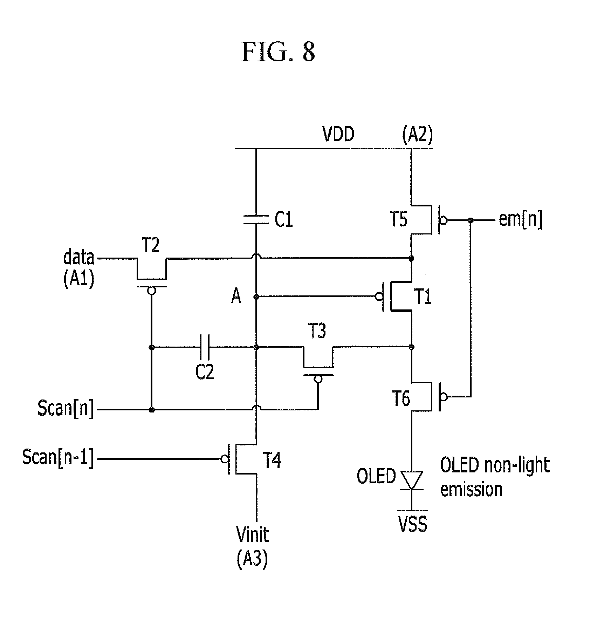

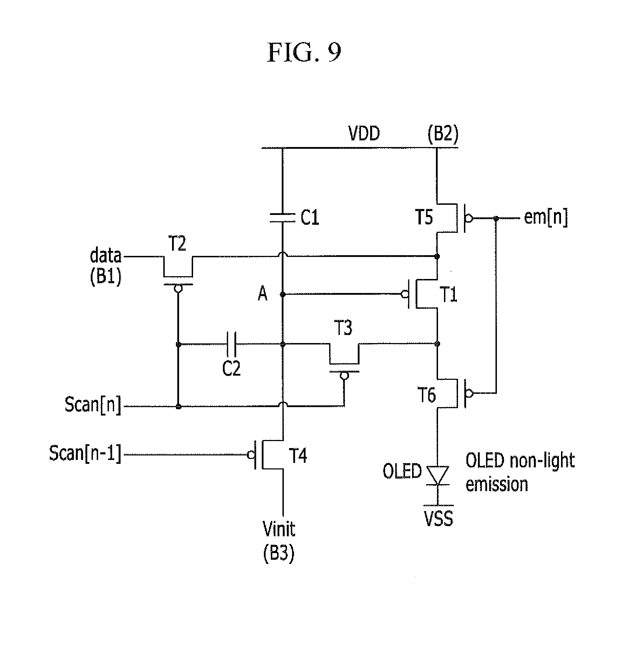

FIG. 8 shows a voltage relationship when a black lighting signal is applied to the OLED display, and FIG. 9 shows a voltage relationship when a lighting signal is applied according to the method for repairing the display device according to this embodiment.

As shown in FIG. 8, one pixel of an OLED display includes a plurality of signal lines Scan[n], Scan[n-1], Vinit, em[n], data, and VDD, a plurality of thin film transistors T1, T2, T3, T4, T5, and T6 respectively connected to the plurality of signal lines, capacitors C1 and C2, a light emission unit, and an organic light emitting diode (OLED).

The thin film transistors include a driving thin film transistor T1, a switching thin film transistor T2, a compensation thin film transistor T3, an initialization thin film transistor T4, a first light emission control thin film transistor T5, and a second light emission control thin film transistor T6, and the capacitors C1 and C2 include a storage capacitor C1 and a boosting capacitor C2. The signal lines include a scan line Scan[n] transmitting a scan line, a previous scan line Scan[n-1] transmitting a previous scan signal, a light emission control line em[n] transmitting a light emission control signal to the first and second light emission control thin film transistors T5 and T6, a data line data crossing the scan line and transmitting a data signal, a driving voltage line VDD formed almost in parallel with the data line and transmitting a data voltage, and an initialization voltage line Vinit transmitting an initialization voltage for initialization of the driving thin film transistor T1. The switching thin film transistor T2 performs switching operation according to the scan signal transmitted through the scan line 121. The driving thin film transistor T1 receives the data signal according to the switching operation of the switching thin film transistor T2 and supplies a driving current to the organic light emitting diode OLED.

A drain electrode of the driving thin film transistor T1 may be electrically connected with an anode of the organic light emitting diode OLED. In addition, a cathode of the organic light emitting diode OLED may be connected with a common voltage ELVSS. Accordingly, the organic light emitting diode OLED emits light by receiving the driving current from the driving thin film transistor T1 to thereby display an image.

In order to detect a defect part in the pixel, a light emission unit of the pixel applies a lighting signal that corresponds to a signal condition that causes emission of less photon than the defect part or a signal condition that causes non-light emission of the light emission unit to the data line data or the driving voltage line VDD of the display device 100, and applies a lighting signal that corresponds to a signal condition that causes emission of photons from the defect part in the pixel to the data line data or the driving voltage line VDD of the display device 100.

That is, as shown in FIG. 8, when lighting signals A1, A2, and A3 that correspond to the signal condition that causes non-light emission from the light emission unit of the pixel are applied to the data line data or the driving voltage line VDD of the display device 100, the defect part in the pixel does not emit photons.

However, as shown in FIG. 9, lighting signals B1, B2, and B3 that correspond to the signal condition that causes the non-light emission from the light emission unit of the pixel and, at the same time, correspond to the signal condition that causes the emission of photons from the defect part in the pixel are applied to the data line data or the driving voltage line VDD of the display device 100.

Next, as shown in FIG. 7, an accurate position of the detect part P in the pixel may be determined by detecting photons or heat using the detector 30 disposed in an upper portion of the display device 100 as shown in FIG. 5 (S500). In this case, the display device 100 and the detector 30 may be provided in a light blocking box 40 that blocks entrance of external light to thereby detect weak photon or heat, and an optical microscopic 50, a laser repairing device 60, a stage 10, and a lighting device 20 may be provided in the light blocking box 40.

In this case, when a photon or heat is not detected in the front side of the display device 100, the display device 100 may be rotated by 180 degrees and a lighting signal may be applied thereto by using the lower probe 212 for the detector 30 to detect the photo or heat in the bottom side of the display device 100.

Next, the pixel may be repaired by irradiating laser beam to the defect part in the pixel (S600) as shown in FIG. 5.

Next, after the pixel is repaired, it may be determined whether the pixel is normal using the lighting device 20 as shown in FIG. 5 (S700).

As described, when a location of the defect part in the pixel can be detected using the optical microscopic 50, the pixel may be repaired by using the laser repairing device 60. When the location of the defect part in the pixel cannot be detected by using the optical microscopic 50, the defect part may be controlled to emit photons or heat and the light emission portion of the pixel by applying a lighting signal having a signal condition that causes emission of less photons or heat than the defect part or a signal condition that causes non-light emission from the light emission portion to the defect part for emission of photons or heat. Then the location of the defect part in the pixel may be detected by using the detector 60 and the pixel can be repaired using the laser repairing device 60.

While this disclosure has been described in connection with what are presently considered to be practical embodiments of the present invention, it is to be understood that the invention is not limited to the disclosed embodiments, but, on the contrary, is intended to cover various modifications and equivalent arrangements included within the scope of the appended claims.

## Claims

1. A repairing apparatus of a display device comprising:
a stage where a display device is mounted;
a lighting device applying a lighting signal to the display device; and
a detector disposed at a distance from the display device for detecting a photon or heat generated from a defect part in a pixel of the display device.

2. A repairing apparatus according to claim 1, further comprising:
a light blocking box surrounding the stage and the detector for blocking introduction of external light into the display device.

3. A repairing apparatus according to claim 1 or 2, wherein the lighting signal has a signal condition that causes emission of a photon or heat from a defect part of the pixel and simultaneously causes lower emission of photons or heat than the defect part from a light emission unit of the pixel, or a signal condition that causes non-light emission of the light emission unit.

4. A repairing apparatus according to any preceding claim, wherein the detector is one selected from a Si-detector having a light receiving part formed of a Si material, an InGaAs-detector having a light receiving part formed of an InGaAs material, a GaAs material, or InGaAsP material, and an InSb-detector having a light receiving part formed of an InSb material.

5. A repairing apparatus according to claim 4, wherein the light blocking box blocks light of a wider wavelength range than a wavelength range of the photon or heat detected by the detector.

6. A repairing apparatus according to any preceding claim, wherein the detector is disposed in an upper or lower side of the stage.

7. A repairing apparatus according to any preceding claim, wherein the lighting device comprises a lighting probe contacting a pad of the display device and a lighting signal generator generating the lighting signal applied to the lighting probe.

8. A repairing apparatus according to any preceding claim, wherein the stage comprises:
a carrying unit carrying the display device and
a rotatable rotating unit provided in an opening formed in the carrying unit, wherein the said display device is mounted in the rotating unit.

9. A repairing apparatus of claim 8, wherein the rotating unit rotates with respect to a rotation shaft that connects the carrying unit and the rotating unit.

10. A repairing apparatus of claim 7, 8 or 9, wherein the lighting probe further comprises an upper probe disposed in an upper side of the state and a lower probe disposed in a lower side of the stage.

11. A repairing apparatus according to any preceding claim, further comprising:
a laser repairing device disposed at a distance from the display device and repairing the pixel by irradiating laser beam.

12. A repairing apparatus of according to any preceding claim, further comprising:
an optical microscopic disposed in an upper or lower side of the stage adapted to perform an optical test with respect to the pixel of the display device.

13. A method for repairing a display device, wherein the method comprises:
detecting a defect part in a pixel by performing an optical test on a display device mounted in a stage using an optical microscopic;
applying a lighting signal to the pixel by contacting a lighting device to the display device for emission of photons or heat from the defect part in the pixel when the defect part in the pixel is not detected by using the optical microscopic;
determining the defect part in the pixel by detecting the photon or heat using a detector; and
repairing the pixel by irradiating laser beam to the defect part in the pixel.

14. A method for repairing the display device according to claim 13, wherein the display device and the detector are provided in a light blocking box that blocks entrance of external light.

15. A method for repairing the display device according to claim 13 or 14, wherein the lighting signal has a signal condition that causes emission of photons or heat from a defect part in the pixel and at the same time causes lower emission of photons or heat than the defect part from a light emission portion of the pixel, or a signal condition that causes non-light emission of the light emission portion.

16. A method for repairing the display device according to claim 13, 14 or 15, wherein the detector is one selected from a Si-detector having a light receiving part formed of a Si material, an InGaAs-detector having a light receiving part formed of an InGaAs material, a GaAs material, or InGaAsP material, and an InSb-detector having a light receiving part formed of an InSb material.

17. A method for repairing the display device according to any one of claims 13 to 16, wherein the method further comprises detecting microphoton or heat generated from a bottom side of the display device by rotating the display device by 180 degrees.

18. A method for repairing the display device according to any one of claims 13 to 17, wherein the method further comprises determining whether the repaired pixel is normal using the lighting device.

19. A method for repairing the display device according to any of claims 13 to 18, wherein, when the defect part in the pixel is detected using the optical microscopic, the pixel is repaired by irradiating laser beam to the defect part in the pixel.
